# EUROPÄISCHE PATENTSCHRIFT

(11) **EP 2 222 150 B1**
(45) Veröffentlichungstag und Bekanntmachung des Hinweises auf die Patenterteilung: **14.10.2015**
(21) Anmeldenummer: 10001380.4
(22) Anmeldetag: 11.02.2010
(51) Int. Cl.: H05K 7/20, H01L 23/473, H01L 23/467

(54) **Leiterplatte mit Kühlkörper**
Circuit board with cooling unit
Plaquette dotée d'un corps de refroidissement

(30) Priorität: 24.02.2009 DE 102009010256
(43) Veröffentlichungstag der Anmeldung: 25.08.2010
(73) Patentinhaber: Jungheinrich Aktiengesellschaft, 22047 Hamburg (DE)
(72) Erfinder: Schuldt, Thomas, 22179 Hamburg (DE)
(74) Vertreter: Hauck Patentanwaltspartnerschaft mbB

(56) Entgegenhaltungen:
- DE-A1- 4 326 207
- DE-A1- 10 249 436
- DE-T2- 69 821 779
- US-A- 3 764 856
- US-A1- 2005 083 652
- US-A1- 2007 215 325
- US-B1- 7 190 581

## Beschreibung

Die Erfindung bezieht sich auf eine Leiterplatte mit Kühlkörper nach Patentanspruch 1.

Es ist allgemein bekannt, Leiterplatten an Kühlkörpern anzubringen, die die von den elektrischen Bauelementen erzeugte Verlustwärme abführen. Dies ist insbesondere der Fall bei Leiterplatten mit Leistungshalbleitern, wie sie z. B. bei der Versorgung von elektrischen Verbrauchern, z. B. Elektromotoren eingesetzt werden.

Die bei Leiterplatten entstehende Wärmeenergie ist zum Teil beträchtlich, so dass verschiedene Versuche unternommen werden, den Wärmeübergang von der Leiterplatte zum Kühlkörper hin zu verbessern. Eine Möglichkeit besteht darin, zwischen Kühlkörper und Leiterplatte eine Wärmeleitpaste anzuordnen, um vorhandene Mikroluftspalten zu überbrücken. Diese Überbrückung gelingt oft nur teilweise. Außerdem weisen derartige Pasten auch nur eine bedingt hohe Wärmeleitfähigkeit auf und behindern die Wärmeleitung von zwei sich berührenden Metallflächen.

Aus EP 1 858 313 A1 ist auch bekannt, durch eine Leiterplatte und einen Kühlkörper mindestens einen Kanal zu formen, durch den ein kühlendes Fluid zirkuliert, z. B. Wasser. Eine derartige Vorkehrung zur besseren Kühlung einer Leiterplatte ist zwar wirksam, aber mit einem erheblichen Aufwand verbunden.

Die DE 102 49 436 A1 offenbart eine Leiterplatte mit Kühlkörper nach dem Oberbegriff von Anspruch 1.

Der Erfindung liegt die Aufgabe zugrunde, eine Leiterplatte mit Kühlkörper so auszubilden, dass mit relativ geringem Aufwand der Wärmeübergang von der Leiterplatte zum Kühlkörper verbessert wird.

Diese Aufgabe wird durch die Merkmale des Anspruchs 1 gelöst.

Bei der Erfindung ist die Leiterplatte abgedichtet an dem Kühlkörper befestigt, und innerhalb der Abdichtung ist in dem Kühlkörper eine Ausnehmung vorgesehen. In den dadurch gebildeten, abgedichteten Raum ist ein Kühlfluid gefüllt.

In einer Ausgestaltung der Erfindung kann das Kühlfluid ein Gas, eine Flüssigkeit oder ein Gel sein. In einer weiteren Ausgestaltung der Erfindung ist das Kühlfluid ein Öl oder ein Wasser-Glykol-Gemisch.

Ist an der Leiterplattenunterseite eine elektrische Verbindung zur Leiterplattenoberseite vorgesehen, ist nach einer Ausgestaltung der Erfindung das Kühlfluid elektrisch nicht leitend.

Bei der Erfmdung leitet das Kühlmittel die Verlustwärme direkt an die Kühlkörperwandung weiter ohne Wärmeübergangswiderstände überbrücken zu müssen. Dadurch arbeitet der Kühlkörper effektiver, weil der Temperaturunterschied zwischen Umgebung und Kühlkörperfläche größer wird.

Die Abdichtung zwischen Leiterplatte und Kühlkörper wird in einer weiteren Ausgestaltung der Erfmdung durch ein die Ausnehmung umgebendes Dichtelement zwischen Leiterplatte und Kühlkörper hergestellt. Das Dichtelement ist vorzugsweise in einer Nut des Kühlkörpers angeordnet.

Bei unterschiedlichen Temperaturen weist das Kühlfluid naturgemäß ein unterschiedliches Volumen auf. Volumenänderungen können z. B. durch die Elastizität der Leiterplatte aufgefangen werden. Alternativ wird bei einer Ausgestaltung der Erfindung vorgeschlagen, dass mit der Ausnehmung ein Ausgleichsvolumen verbunden ist, in das das Kühlfluid bei Ausdehnung fließen kann. Eine besonders einfache Möglichkeit, ein Ausgleichsvolumen bereitzustellen, besteht nach einer Ausgestaltung der Erfindung in einem schwammähnlichen Körper, der in die Ausnehmung eingebracht wird. Der schwammähnliche Körper, der als flaches, vorzugsweise rechteckiges Gebilde ausgeführt ist, ist vorzugsweise mit einer mittigen Bohrung versehen, mit der zwecks Lagefixierung ein Zapfen in der Ausnehmung des Kühlkörpers zusammenwirkt.

Die Erfindung wird nachfolgend anhand einer Zeichnung näher erläutert.
- Figur 1: zeigt einen Schnitt durch eine Leiterplatte mit Kühlkörper nach der Erfindung.
- Figur 2: zeigt perspektivisch einen alternativen Kühlkörper mit einem schwammähnlichen Körper zwecks Volumenausgleich.

In der Figur ist eine Leiterplatte 10 zu erkennen, die einzelne elektrische bzw. elektronische Bauelemente enthält, die jedoch nicht dargestellt sind. Bei den Bauelementen handelt es sich z. B. um Leistungsbauelemente. Daher kann die Leiterplatte z. B. die Leistungshalbleiter und ihre Steuerung für die Versorgung eines elektrischen Motors erheblich erwärmt werden. In jedem Falle erzeugen die Bauelemente in einer derartigen Leiterplatte eine große Verlustwärme. Diese wird in der Figur durch einen hier quaderförmig dargestellten Kühlkörper 12 aus gut wärmeleitendem Material abgeführt. Als Material dient z. B. Aluminium oder eine Aluminiumlegierung. Der Kühlkörper 12 kann mit Kühlrippen oder dergleichen versehen werden, um eine bessere Wärmeabfuhr an die Umgebung zu gewährleisten.

Wie erkennbar, befindet sich im Kühlkörper 12 unterhalb der Leiterplatte 10 eine Ausnehmung 14. An der der Leiterplatte 10 zugekehrten Oberseite des Kühlkörpers 12 ist eine die Ausnehmung 14 umgebende Nut 16 eingeformt, welche ein Dichtelement 18 aufnimmt, z. B. ein O-Dichtring. Die Leiterplatte 10 wird mit geeigneten Mitteln am Kühlkörper 12 befestigt, beispielsweise durch Verschraubung. Nach der Anbringung der Leiterplatte 10 am Kühlkörper 12 ist der Raum, der durch die Ausnehmung 14 gebildet ist, gegenüber der Umgebung abgedichtet. Er ist mit einem geeigneten Kühlfluid 20 gefüllt. Das Kühlfluid ist z. B. ein Gas, eine Flüssigkeit oder ein Gel. Vorzugsweise wird ein flüssiges Kühlmittel auf Öl- oder Wasser-Glykol-Mischung-Basis verwendet.

Das Kühlfluid 20 füllt alle Spalten zwischen Kühlkörper 12 und Leiterplatte 10 aus, wodurch ein guter Wärmeübergang von der Leiterplatte 10 zum Kühlkörper gewährleistet ist, wenn das Kühlmedium 20 selbst eine relativ gute Wärmeleiteigenschaft aufweist. Die beschriebene Flachbaugruppe wird so montiert, dass die Randebene zur Flachbaugruppenunterseite flüssigkeitsdicht ist. Dies kann z.B. auch durch vorheriges Kleben der Flachbaugruppe auf den Kühlkörper erfolgen oder durch Dichtlippen zwischen Flachbaugruppe und Kühlkörper, welche erst durch Montage des Deckels dicht gepresst wird. Bei der Montage ist das Ausgleichsvolumen bereits vorhanden und positioniert. Idealerweise wird der Kühlkörper mit montierter Flachbaugruppe aufgerichtet und vom höchsten Punkt aus befüllt mit Geliermittel und Kühlflüssigkeit. Der Gelierprozess findet während des Befiillens statt. So wird verhindert, dass unnötig Luft mit eingeschlossen wird. Sobald Flüssigkeit oben austritt, wird die Öffnung mit einem Schraub- oder Steckstopfen verschlossen.

Weist die Unterseite der Platte 10 eine elektrische Verbindung auf, dann ist das Kühlfluid 20 elektrisch nicht leitend auszuführen.

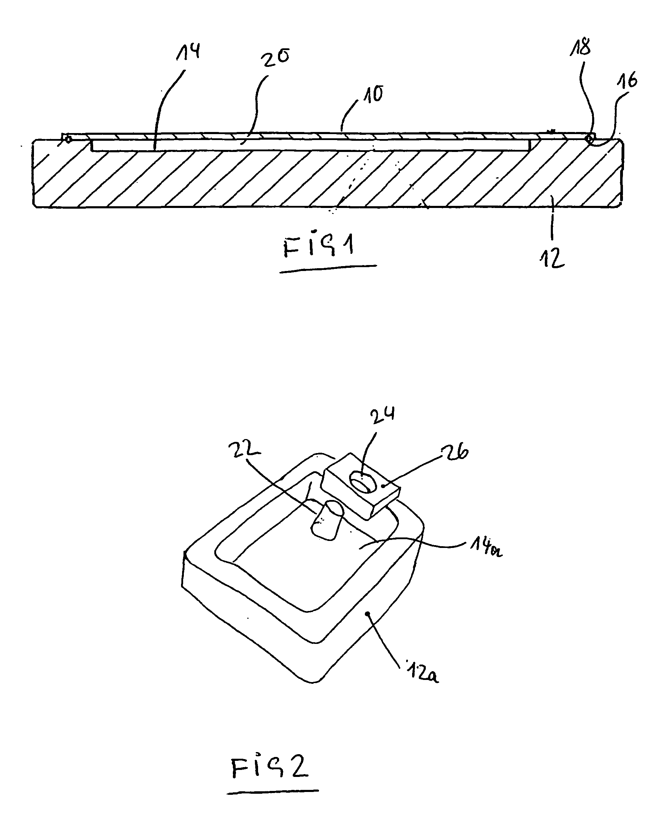

In Figur 2 ist ein Kühlkörper 12a dargestellt mit einer Ausnehmung 14a ähnlich der Anordnung nach Figur 1. In der Ausnehmung 14a ist ein Zapfen 22 angeordnet, der mit einer mittigen Bohrung 24 eines flachen schwammähnlichen Körpers 26 zusammenwirkt. Der schwammähnliche Körper 26 ist komprimierbar und dient somit als Ausgleichsvolumen bei Temperaturänderungen und damit Volumenänderungen der Kühlflüssigkeit.

## Patentansprüche

1. Leiterplatte mit Kühlkörper, wobei der Kühlkörper mindestens eine von der Leiterplatte abgedeckte Ausnehmung aufweist für ein Kühlfluid, **dadurch gekennzeichnet, dass** die Leiterplatte (10) abgedichtet am Kühlkörper (12) befestigt und der so abgedichtete Raum der Ausnehmung (14) mit dem Kühlfluid (20) gefüllt ist.

2. Leiterplatte mit Kühlkörper nach Anspruch 1, **dadurch gekennzeichnet, dass** das Kühlfluid ein Gas, eine Flüssigkeit oder ein Gel ist.

3. Leiterplatte mit Kühlkörper nach Anspruch 2, **dadurch gekennzeichnet, dass** das Kühlfluid ein Öl oder eine Wasser-Glykol-Mischung ist.

4. Leiterplatte mit Kühlkörper nach einem der Ansprüche 1 - 3, **dadurch gekennzeichnet, dass** das Kühlfluid (20) elektrisch nicht leitend ist.

5. Leiterplatte mit Kühlkörper nach einem der Ansprüche 1 - 4, **dadurch gekennzeichnet, dass** im Kühlkörper ein mit der Ausnehmung verbundenes oder in der Ausnehmung angeordnetes Ausgleichsvolumen vorgesehen ist.

6. Leiterplatte mit Kühlkörper nach Anspruch 6, **dadurch gekennzeichnet, dass** das Ausgleichsvolumen von einem komprimierbaren Körper (26) gebildet ist.

7. Leiterplatte mit Kühlkörper nach Anspruch 6, **dadurch gekennzeichnet, dass** der komprimierbare Körper (26) eine Bohrung (24) aufweist, in die ein Stift (22) in der Ausnehmung (14a) eingreift.

8. Leiterplatte mit Kühlkörper nach einem der Ansprüche 1 - 7, **dadurch gekennzeichnet, dass** zwischen Leiterplatte (10) und Kühlkörper (12) ein die Ausnehmung (14) umgebendes Dichtelement (18) angeordnet ist.

9. Leiterplatte mit Kühlkörper nach Anspruch 8, **dadurch gekennzeichnet, dass** das Dichtelement (18) in einer Nut (16) des Kühlkörpers (20) angeordnet ist.

## Claims

1. A circuit board with cooling unit, wherein the cooling unit has at least one recess covered by the circuit board for a cooling fluid, **characterized in that** the circuit board (10) is fastened in a sealed manner on the cooling unit (12) and the space of the recess (14) sealed in this manner is filled with the cooling fluid (20).

2. The circuit board with cooling unit according to claim 1, **characterized in that** the cooling fluid is a gas, a liquid or a gel.

3. The circuit board with cooling unit according to claim 2, **characterized in that** the cooling fluid is an oil or a water/glycol mixture.

4. The circuit board with cooling unit according to one of claims 1 - 3, **characterized in that** the cooling fluid (20) is not electroconductive.

5. The circuit board with cooling unit according to one of claims 1 - 4, **characterized in that** an equalizing volume connected with the recess or arranged in the recess is provided in the cooling unit.

6. The circuit board with cooling unit according to claim 6, **characterized in that** the equalizing volume is formed by a compressible body (26).

7. The circuit board with cooling unit according to claim 6, **characterized in that** the compressible body (26) has a bore hole (24), into which a pin (22) in the recess (14a) engages.

8. The circuit board with cooling unit according to one of claims 1 - 7, **characterized in that** a sealing element (18) surrounding the recess (14) is arranged between the circuit board (10) and cooling unit (12).

9. The circuit board with cooling unit according to claim 8, **characterized in that** the sealing element (18) is arranged in a groove (16) of the cooling unit (20).

## Revendications

1. Plaquette dotée d'un corps de refroidissement, le corps de refroidissement présentant au moins un creux, recouvert par la plaquette, pour un fluide de refroidissement, **caractérisée en ce que** la plaquette (10) est fixée de manière étanche sur le corps de refroidissement (12) et **en ce que** l'espace du creux (14) ainsi rendu étanche est rempli avec le fluide de refroidissement (20).

2. Plaquette dotée d'un corps de refroidissement selon la revendication 1, **caractérisée en ce que** le fluide de refroidissement est un gaz, un liquide ou un gel.

3. Plaquette dotée d'un corps de refroidissement selon la revendication 2, **caractérisée en ce que** le fluide de refroidissement est une huile ou un mélange eauglycol.

4. Plaquette dotée d'un corps de refroidissement selon l'une des revendications 1 à 3, **caractérisée en ce que** le fluide de refroidissement (20) n'est pas électriquement conducteur.

5. Plaquette dotée d'un corps de refroidissement selon l'une des revendications 1 à 4, **caractérisée en ce que**, dans le corps de refroidissement, il est prévu un volume de compensation raccordé au creux ou disposé dans le creux.

6. Plaquette dotée d'un corps de refroidissement selon la revendication 6, **caractérisée en ce que** le volume de compensation est formé d'un corps (26) compressible.

7. Plaquette dotée d'un corps de refroidissement selon la revendication 6, **caractérisée en ce que** le corps (26) compressible présente un alésage (24) dans lequel engrène une broche (22) dans le creux (14a).

8. Plaquette dotée d'un corps de refroidissement selon l'une des revendications 1 à 7, **caractérisée en ce que**, entre la plaquette (10) et le corps de refroidissement (12), il est disposé un élément d'étanchéité (18) entourant le creux (14).

9. Plaquette dotée d'un corps de refroidissement selon la revendication 8, **caractérisée en ce que** l'élément d'étanchéité (18) est disposé dans une rainure (16) du corps de refroidissement (20).
